# EUROPÄISCHE PATENTANMELDUNG

(11) **EP 4 486 080 A1**
(43) Veröffentlichungstag der Anmeldung: **01.01.2025**
(21) Anmeldenummer: 23181474.0
(22) Anmeldetag: 26.06.2023
(51) Int. Cl.: H05K 7/14

(54) **ELEKTRONISCHE LEISTUNGSBAUGRUPPE MIT VERBESSERTEM AUFBAU**

(71) Anmelder: Siemens Aktiengesellschaft, 80333 München (DE)
(72) Erfinder: Frana, Christian, 90556 Cadolzburg (DE); Lodes, Stefan, 91278 Pottenstein (DE); Rövenstrunck, Martin, 91126 Schwabach (DE)
(74) Vertreter: Siemens Patent Attorneys

(57) **Zusammenfassung**

Eine elektronische Leistungsbaugruppe, die insbesondere als Umrichtereinheit ausgebildet sein kann, weist eine Leiterplatte (1) auf, welche Leiterbahnen (2) zum Führen von Leistungsströmen aufweist. Die Leistungsbaugruppe weist weiterhin eine oberhalb der Leiterplatte (1) angeordnete Zusatzeinheit (5) auf, die eine der Leiterplatte (1) zugewandte Unterseite (6) aufweist. Die Zusatzeinheit (5) weist elektronische Komponenten (7) auf, die mit den Leiterbahnen (2) der Leiterplatte (1) über Verbindungseinheiten (9) elektrisch verbunden sind. Die Verbindungseinheiten (9) weisen jeweils einen Steckkontakt (10) und eine Aufnahme (11) für den jeweiligen Steckkontakt (10) auf. Die Steckkontakte (10) sind an der Unterseite (6) der Zusatzeinheit (5) angeordnet und die Aufnahmen (11) sind direkt oder indirekt an den Leiterbahnen (2) der Leiterplatte (1) befestigt. Alternativ können umgekehrt die Aufnahmen (11) an der Unterseite (6) der Zusatzeinheit (5) angeordnet sein und die Steckkontakte (10) direkt oder indirekt an den Leiterbahnen (2) der Leiterplatte (1) befestigt sein.

## Beschreibung

Die vorliegende Erfindung geht aus von einer elektronischen Leistungsbaugruppe, insbesondere einer Umrichtereinheit,
- wobei die Leistungsbaugruppe eine Leiterplatte aufweist, welche Leiterbahnen zum Führen von Leistungsströmen aufweist,
- wobei die Leistungsbaugruppe eine oberhalb der Leiterplatte angeordnete Zusatzeinheit aufweist, die eine der Leiterplatte zugewandte Unterseite aufweist,
- wobei die Zusatzeinheit elektronische Komponenten aufweist, die mit den Leiterbahnen der Leiterplatte über Verbindungseinheiten elektrisch verbunden sind.

Derartige Leistungsbaugruppen sind allgemein bekannt. Sie werden beispielsweise als Stromversorgungseinrichtungen für elektrische Antriebe eingesetzt.

Bei den Leistungsbaugruppen des Standes der Technik umfassen die Verbindungseinheiten Schrauben, die in entsprechende Gewinde eingedreht werden. Dies ist nachteilig, weil der Schraubenkopf jeder Schraube zugänglich sein muss. Somit blockiert jede Stelle, an der eine Schraube eingedreht werden soll, oberhalb des Schraubenkopfes ein größeres Volumen, das freigehalten werden muss und nicht für andere Zwecke - insbesondere die Anordnung von elektronischen Komponenten oder Leiterbahnen - genutzt werden kann.

Die Aufgabe der vorliegenden Erfindung besteht darin, Möglichkeiten zu schaffen, mittels derer der für die Anordnung von mechanischen und elektrischen Elementen (einschließlich Leiterbahnen) zur Verfügung stehende Bauraum der Zusatzeinheit und auch der Leistungsbaugruppe insgesamt vergrößert werden kann.

Die Aufgabe wird durch eine elektronische Leistungsbaugruppe mit den Merkmalen des Anspruchs 1 gelöst. Vorteilhafte Ausgestaltungen der elektronischen Leistungsbaugruppe sind Gegenstand der abhängigen Ansprüche 2 bis 6.

Erfindungsgemäß wird eine elektronische Leistungsbaugruppe der eingangs genannten Art dadurch ausgestaltet,
- dass die Verbindungseinheiten jeweils einen Steckkontakt und eine Aufnahme für den jeweiligen Steckkontakt aufweisen und
- dass die Steckkontakte an der Unterseite der Zusatzeinheit angeordnet sind und die Aufnahmen direkt oder indirekt an den Leiterbahnen der Leiterplatte befestigt sind oder umgekehrt die Aufnahmen an der Unterseite der Zusatzeinheit angeordnet sind und die Steckkontakte direkt oder indirekt an den Leiterbahnen der Leiterplatte befestigt sind.

Insbesondere wurde erkannt, dass für das Herstellen der elektrischen Verbindungen zwischen der Leiterplatte und der Zusatzeinheits Schraubverbindungen nicht erforderlich sind. Insbesondere müssen die elektrischen Verbindungen - mit Ausnahme der Kontaktkräfte, die zur Gewährleistung der gewünschten Stromtragfähigkeit der Verbindungseinheiten erforderlich sind - keine mechanischen Kräfte aufnehmen und übertragen können.

Die von den Leiterbahnen geführten Leistungsströme liegen in aller Regel bei 10 A und mehr. Oftmals liegen sie bei 100 A oder sogar mehreren 100 A, in extremen Fällen sogar bei über 1 kA. Schaltelemente zum Schalten der Leistungsströme sind meist entweder direkt auf der Leiterplatte angeordnet oder auf einem Substrat angeordnet, das seinerseits auf der Leiterplatte angeordnet ist. Mittels der Schaltelemente werden in der Regel Spannungen von 100 V und mehr geschaltet, meist Spannungen von mehreren 100 V, in manchen Fällen sogar Spannungen oberhalb von 1 kV, im Extremfall bis zu 3,0 kV oder 3,3 kV. Im gleichen Ausmaß kann im Laufe der Zeit auch das Potenzial variieren, das eine bestimmte derartige Leiterbahn aufweist bzw. führt.

Steckkontakte, die für das Führen der erforderlichen Leistungsströme geeignet sind, sind als solche bekannt. Rein beispielhaft kann auf die DE 10 2021 119 087 A1 und auf die DE 10 2021 119 087 A1 verwiesen werden.

In manchen Fällen kann die Zusatzeinheit direkt auf der Leiterplatte angeordnet sein. Vorzugsweise weist die Leistungsbaugruppe jedoch eine aus einem elektrisch isolierenden Material, insbesondere einem Kunststoff, bestehende Brückenstruktur auf, die an ihrer von der Leiterplatte abgewandten und der Zusatzeinheit zugewandten Oberseite eine Auflagefläche aufweist. In diesem Fall bildet die Brückenstruktur eine Montageebene für die Zusatzeinheit und liegt die Zusatzeinheit mit ihrer Unterseite direkt oder über ein Zwischenelement auf der Auflagefläche der Brückenstruktur auf. Dadurch kann insbesondere auch der unter der Brückenstruktur befindliche Bauraum der Leistungsbaugruppe für die Anordnung von elektronischen Bauelementen genutzt werden.

Im Falle der Verwendung der Brückenstruktur weist die Leistungsbaugruppe vorzugsweise abgewinkelte Stromschienen auf, die jeweils einen Leiterplatten-Endabschnitt, einen Zusatzeinheits-Endabschnitt und einen die beiden jeweiligen Endabschnitte verbindenden Zwischenabschnitt aufweisen. In diesem Fall verlaufen die Leiterplatten-Endabschnitte parallel zur Leiterplatte und sind an den Leiterbahnen befestigt. Die Zwischenabschnitte erstrecken sich im wesentlichen orthogonal zur Leiterplatte. Die Zusatzeinheits-Endabschnitte verlaufen in der Montageebene. An den von den Zwischenabschnitten abgewandten Enden der Zusatzeinheits-Endabschnitte ist jeweils eine der Aufnahmen oder einer der Steckkontakte befestigt.

Diese Ausgestaltung ermöglicht auf einfache und zuverlässige Weise eine Anordnung der leiterplattenseitigen Elemente der Verbindungseinheiten (also der direkt oder indirekt mit den Leiterbahnen der Leiterplatte elektrisch und mechanisch verbundenen Aufnahmen oder Steckkontakte) in der Montageebene für die Zusatzeinheit.

Vorzugsweise stehen die Zusatzeinheits-Endabschnitte in der Montageebene gesehen über die Brückenstruktur über, so dass die an den von den Zwischenabschnitten abgewandten Enden der Zusatzeinheits-Endabschnitte angeordneten Aufnahmen oder Steckkontakte beim Aufsetzen der Zusatzeinheit auf die Brückenstruktur in Richtung auf die Leiterplatte zu nachgeben können. Dadurch kann auf einfache Art und Weise ein Toleranzausgleich erfolgen.

Vorzugsweise sind die Aufnahmen oder die Steckkontakte in die Zusatzeinheits-Endabschnitte eingepresst. Diese Ausgestaltung bietet fertigungstechnische Vorteile beim Herstellen der Stromschienen.

Vorzugsweise sind die an der Unterseite der Zusatzeinheit angeordneten Steckkontakte oder Aufnahmen gegenüber der Unterseite der Zusatzeinheit zurückgesetzt, so dass die Steckkontakte oder Aufnahmen bezüglich der Unterseite der Zusatzeinheit versenkt angeordnet sind. Diese Ausgestaltung schützt die entsprechenden Steckkontakte oder Aufnahmen bei der Handhabung der Zusatzeinheit vor einer Beschädigung. Ferner können dadurch Luft- und Kriechstrecken und damit die Spannungsfestigkeit der Leistungsbaugruppe vergrößert werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: Bestandteile einer elektronischen Leistungsbaugruppe von der Seite,
- FIG 2: eine Draufsicht auf eine Leiterplatte,
- FIG 3: einen Schnitt durch einen Zusatzteil,
- FIG 4 bis 6: perspektivische Darstellungen von Bestandteilen einer elektronischen Leistungsbaugruppe,
- FIG 7: eine perspektivische Darstellung eines Zusatzteils,
- FIG 8: eine perspektivische Darstellung einer elektronischen Leistungsbaugruppe und
- FIG 9: einen Schnitt durch die Leistungsbaugruppe von FIG 8.

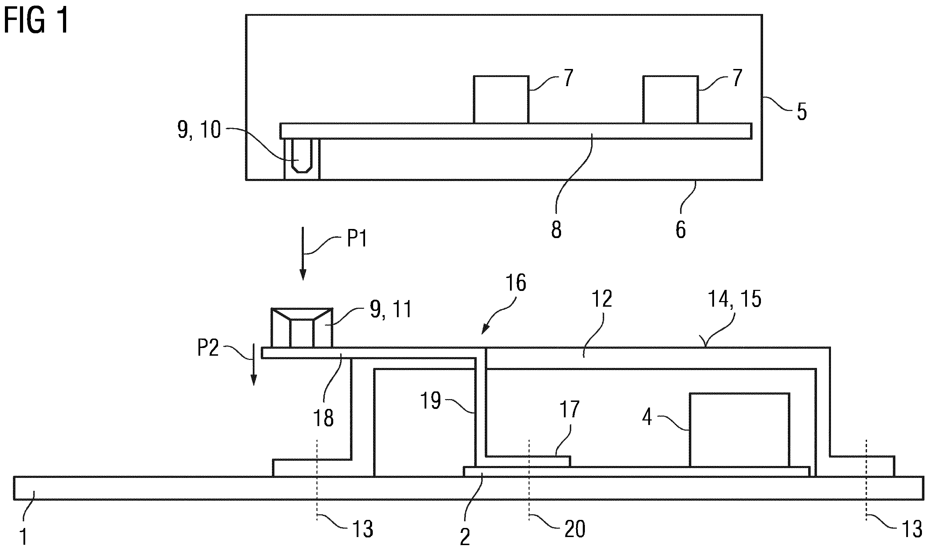

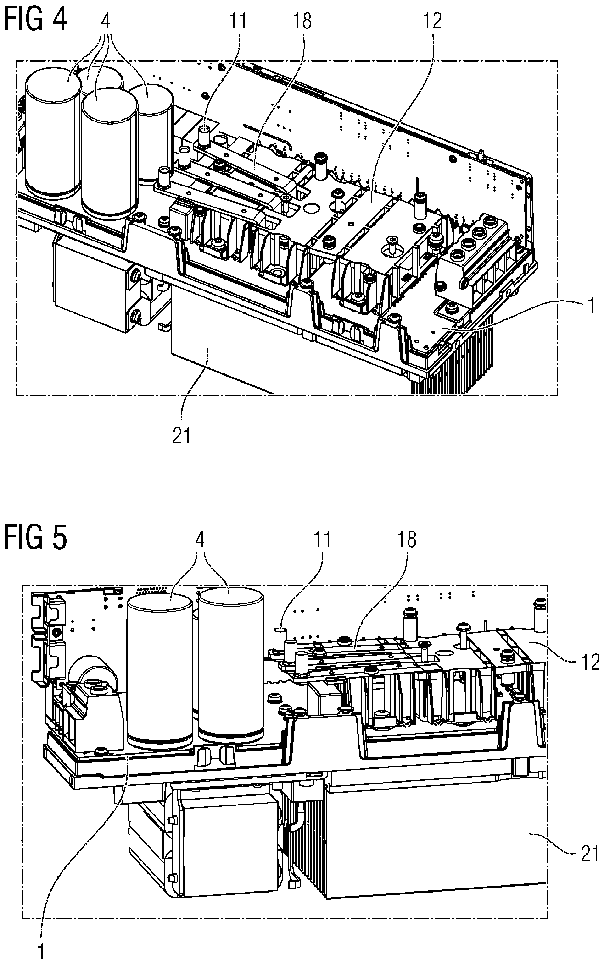

Hierbei sind die FIG 1 bis 3 deutlich schematisiert. In ihnen ist nur ein Bruchteil der tatsächlich vorhandenen Bauelemente usw. dargestellt. Die FIG 4 bis 9 hingegen sind erheblich detaillierter und realitätsnäher.

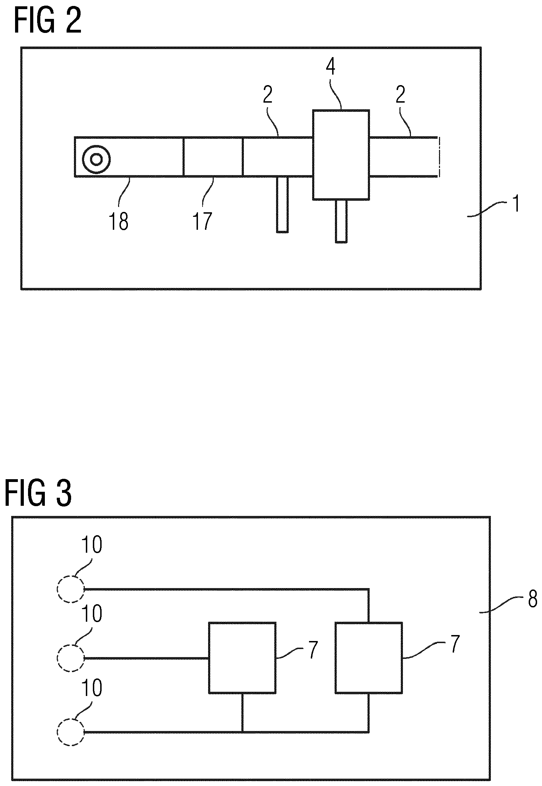

Gemäß den FIG 1 und 2 weist eine elektronische Leistungsbaugruppe eine Leiterplatte 1 auf. Die Leistungsbaugruppe kann beispielsweise eine Umrichtereinheit sein. Die Leiterplatte 1 weist Leiterbahnen 2 und weitere Leiterbahnen 3 auf. Die Leiterbahnen 2 dienen zum Führen von Leistungsströmen. Die weiteren Leiterbahnen 3 dienen für die Übermittlung von Steuersignalen und Messgrößen. Gemäß FIG 2 sind die Leiterbahnen 2 für die Leistungsströme erheblich größer dimensioniert als die weiteren Leiterbahnen 3. Auf die Leiterbahnen 2 und teilweise auch auf die weiteren Leiterbahnen 3 sind oftmals elektronische Bauteile 4 aufgesetzt, beispielsweise im Falle einer Umrichtereinheit Schaltelemente wie Transistoren oder Thyristoren. Die genaue Bauart der Transistoren oder Thyristoren kann nach Bedarf sein, beispielsweise bei Transistoren als Bipolartransistoren, als IGBT oder als FET. In FIG 1 ist nur ein einzelnes derartiges Schaltelement dargestellt. In der Regel sind jedoch mehrere Schaltelemente vorhanden.

Nachfolgend sind nur die Leiterbahnen 2 für die Leistungsströme relevant. Wenn nachfolgend der Begriff "Leiterbahn" verwendet wird, sind hiermit stets die Leiterbahnen 2 für die Leistungsströme gemeint. Die weiteren Leiterbahnen 3 werden nachstehend nicht betrachtet.

Die elektronische Leistungsbaugruppe weist weiterhin eine Zusatzeinheit 5 auf. Die Zusatzeinheit 5 ist oberhalb der Leiterplatte 1 angeordnet. Sie weist eine Unterseite 6 auf, die der Leiterplatte 1 zugewandt ist. Die Zusatzeinheit 5 weist weiterhin elektronische Komponenten 7 auf. Die elektronischen Komponenten 7 können beispielsweise auf einer eigenen Leiterplatte 8 der Zusatzeinheit 5 angeordnet sein. Die elektronischen Komponenten 7 können beispielsweise eine in Umrichtereinheiten übliche Filterschaltung bilden. Die Zusatzeinheit 5 ist in der Darstellung von FIG 1 noch nicht mit der Leiterplatte 1 und den auf der Leiterplatte 1 angeordneten Leiterbahnen 2 verbunden.

Die Leiterplatte 8 der Zusatzeinheit 5 ist im Rahmen der vorliegenden Erfindung von untergeordneter Bedeutung. Wenn daher nachfolgend der Begriff "Leiterplatte" verwendet wird, ist stets die Leiterplatte 1 gemeint, nicht die Leiterplatte 8.

Die elektronischen Komponenten 7 der Zusatzeinheit 5 sind mit den Leiterbahnen 2 der Leiterplatte 1 elektrisch verbunden. Die elektrische Verbindung erfolgt (zumindest) über Verbindungseinheiten 9. In den FIG 1 und 2 ist jeweils nur eine Verbindungseinheit 9 bzw. ein Teil einer Verbindungseinheit 9 dargestellt. In der Regel sind mehrere Verbindungseinheiten 9 vorhanden, beispielsweise entsprechend der Darstellung in FIG 3 drei Verbindungseinheiten 9.

Die Verbindungseinheiten 9 weisen jeweils einen Steckkontakt 10 und eine Aufnahme 11 für den jeweiligen Steckkontakt 10 auf. Gemäß FIG 1 sind die Steckkontakte 10 an der Unterseite 6 der Zusatzeinheit 5 angeordnet. In diesem Fall sind die Aufnahmen 11 direkt oder indirekt an den Leiterbahnen 2 der Leiterplatte 1 befestigt. Alternativ ist auch die umgekehrte Zuordnung möglich. In diesem Fall - in den FIG nicht dargestellt - sind die Aufnahmen 11 an der Unterseite 6 der Zusatzeinheit 5 angeordnet und sind weiterhin die Steckkontakte 10 direkt oder indirekt an den Leiterbahnen 2 der Leiterplatte 1 befestigt. Unabhängig davon, ob die eine oder die andere Ausgestaltungen ergriffen wird, können die Zusatzeinheit 5 und deren elektronische Komponenten 7 daher schlichtweg durch Aufsetzen der Zusatzeinheit 5 auf die Aufnahmen 11 bzw. die Steckkontakte 10 elektrisch mit den Leiterbahnen 2 der Leiterplatte 1 verbunden werden. Das Aufsetzen ist in FIG 1 durch einen Pfeil P1 angedeutet.

Durch das Aufsetzen der Zusatzeinheit 5 auf die Aufnahmen 11 (bzw. die Steckkontakte 10) erfolgt im wesentlichen nur die elektrische Kontaktierung der elektronischen Komponenten 7 der Zusatzeinheit 5 mit den Leiterbahnen 2. Die mechanische Halterung des Zusatzteils 5 wird anderweitig realisiert. Beispielsweise kann ein Bügel vorgesehen sein oder ein Verschrauben erfolgen. Auch andere Ausgestaltungen sind möglich. Dies ist im Rahmen der vorliegenden Erfindung von untergeordneter Bedeutung.

In vielen Fällen weist die Leistungsbaugruppe eine Brückenstruktur 12 auf (bezüglich der FIG 1 bis 3 nur in FIG 1 dargestellt). Die Brückenstruktur 12 besteht, sofern sie vorhanden ist, aus einem elektrisch isolierenden Material, insbesondere einem Kunststoff. Die Brückenstruktur 12 ist auf der Leiterplatte 1 befestigt. Die Befestigung kann nach Bedarf erfolgen, beispielsweise über schematisch angedeutete Schraubverbindungen 13. Die Brückenstruktur 12 weist an ihrer Oberseite 14 - das ist diejenige Seite, die von der Leiterplatte 1 abgewandt und damit gleichzeitig der Zusatzeinheit 5 zugewandt ist - eine Auflagefläche 15 auf. Die Brückenstruktur 12 bildet dadurch eine Montageebene für die Zusatzeinheit 5. Die Zusatzeinheit 5 liegt im einfachsten Fall (siehe FIG 1) direkt auf der Auflagefläche 15 der Brückenstruktur 12 auf.

Im Falle der Brückenstruktur 12 weist die Leistungsbaugruppe weiterhin Stromschienen 16 auf. Die Stromschienen 16 sind abgewinkelt. Sie weisen jeweils einen Leiterplatten-Endabschnitt 17, einen Zusatzeinheits-Endabschnitt 18 und einen Zwischenabschnitt 19 auf.

Die Leiterplatten-Endabschnitte 17 verlaufen parallel zur Leiterplatte 1 und sind an den Leiterbahnen 2 befestigt. Die Verbindung kann nach Bedarf sein, beispielsweise über schematisch angedeutete Schraubverbindungen 20, über Lötverbindungen, über Steckverbindungen und andere mehr. Die genaue Art der Befestigung ist im Rahmen der vorliegenden Erfindung von untergeordneter Bedeutung.

Die Zwischenabschnitte 19 verbinden die beiden Endabschnitte 17, 18 der jeweiligen Stromschiene 16 miteinander. Sie erstrecken sich im wesentlichen orthogonal zur Leiterplatte 1.

Die Zusatzeinheits-Endabschnitte 18 verlaufen in der von der Brückenstruktur 12 gebildeten Montageebene. An den von den Zwischenabschnitten 19 abgewandten Enden der Zusatzeinheits-Endabschnitte 18 ist jeweils einer der Steckkontakte 10 (alternativ: eine der Aufnahmen 11) befestigt.

Gemäß FIG 1 stehen die Zusatzeinheits-Endabschnitte 18 in der Montageebene gesehen über die Brückenstruktur 12 über. Dies gilt insbesondere für die Bereiche der Zusatzeinheits-Endabschnitte 18, in denen die Steckkontakte 10 (alternativ: die Aufnahmen 11) befestigt sind. Dadurch können die entsprechenden Bereiche der Zusatzeinheits-Endabschnitte 18 beim Aufsetzen der Zusatzeinheit 5 auf die Brückenstruktur 12 - wenn auch nur geringfügig - in Richtung auf die Leiterplatte 1 zu nachgeben. Dies ist in FIG 1 durch einen Pfeil P2 angedeutet.

Wie insbesondere aus FIG 1 ersichtlich ist, sind die an der Unterseite 6 der Zusatzeinheit 5 angeordneten Steckkontakte 10 (alternativ: die an der gleichen Stelle angeordneten Aufnahmen 11) gegenüber der Unterseite 6 der Zusatzeinheit 5 zurückgesetzt. Dadurch sind die Steckkontakte 10 (alternativ: die Aufnahmen 11) bezüglich der Unterseite 6 der Zusatzeinheit 5 versenkt angeordnet.

Die FIG 4 bis 9 zeigen - soweit vorliegend relevant - die gleichen Sachverhalte, die vorstehend in Verbindung mit den FIG 1 bis 3 erläutert wurden, anhand einer realen elektronischen Leistungsbaugruppe.

Die FIG 4 und 5 zeigen eine elektronische Leistungsbaugruppe vor dem Aufsetzen der Zusatzeinheit 5. Konkret erkennt man in den FIG 4 und 5 die Leiterplatte 1, einen Teil der elektronischen Bauelemente 4, die Brückenstruktur 12 und deren Ausgestaltung, die Stromschienen 16 und deren Ausgestaltung sowie die Aufnahmen 11. In den FIG 4 und 5 ist nur bei einer der Stromschienen 16 der Zusatzeinheits-Endabschnitt 18 mit seinem Bezugszeichen versehen und ist auch nur eine der Aufnahmen 11 mit ihrem Bezugszeichen versehen. Weiterhin zeigen die FIG 4 und 5 einen üblicherweise vorhandenen Kühlkörper 21.

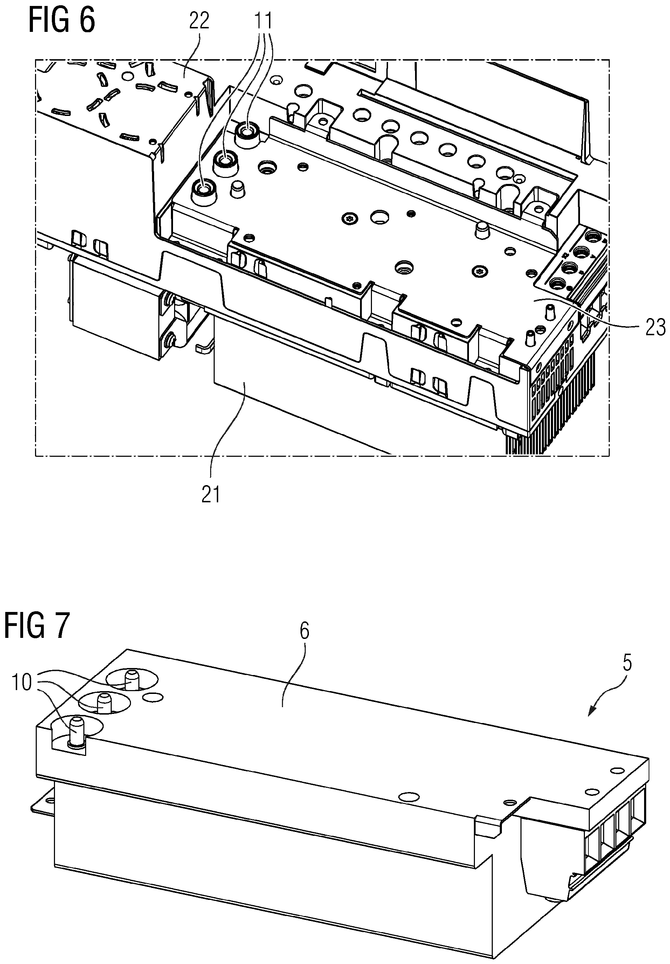

Auch FIG 6 zeigt die elektronische Leistungsbaugruppe der FIG 4 und 5 vor dem Aufsetzen der Zusatzeinheit 5 auf die Brückenstruktur 12. Bei FIG 6 sind auf die Leiterplatte 1 jedoch Abdeckelemente 22, 23 aufgebracht. Das Abdeckelement 23 bildet ein Zwischenelement, das zwischen der Oberseite 14 der Brückenstruktur 12 und der Zusatzeinheit 5 angeordnet ist. Dadurch liegt die Zusatzeinheit 5 mit ihrer Unterseite 6 nicht direkt, sondern nur indirekt über das Abdeckelement 23 auf der Auflagefläche 15 der Brückenstruktur 12 auf.

FIG 7 zeigt die Zusatzeinheit 5. In FIG 7 ist besonders gut zu erkennen, dass die Steckkontakte 10 gegenüber der Unterseite 6 der Zusatzeinheit 5 zurückgesetzt angeordnet sind.

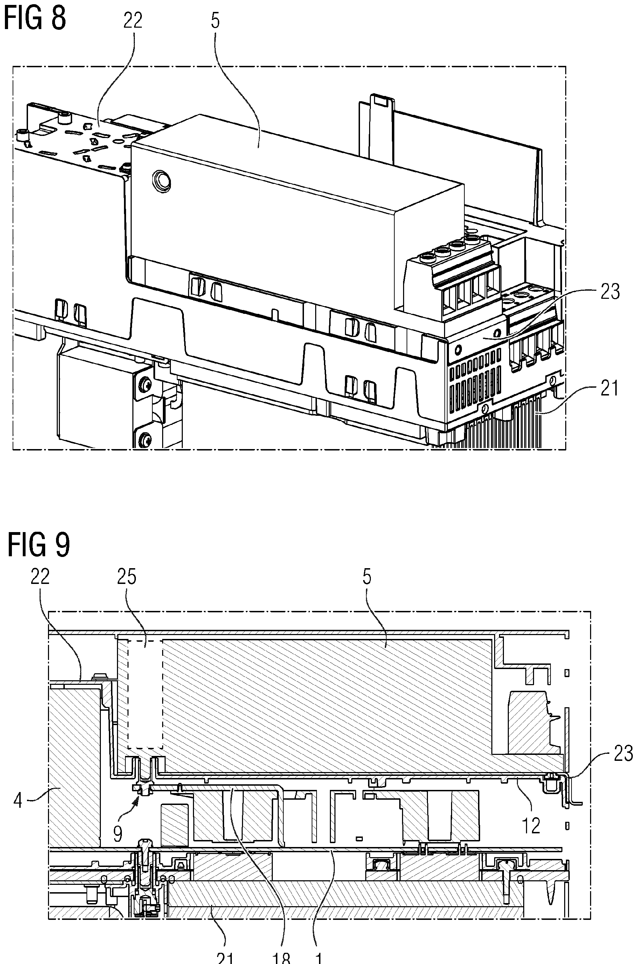

FIG 8 zeigt die elektronische Leistungsbaugruppe nach dem Aufsetzen der Zusatzeinheit 5 auf die Brückenstruktur 12. Man erkennt insbesondere das Fehlen von Ausnehmungen, die im Stand der Technik erforderlich sind, um Verbindungsschrauben betätigen zu können, die im Stand der Technik unter der Zusatzeinheit 5 angeordnet sind.

FIG 9 zeigt einen Schnitt durch die elektronische Leistungsbaugruppe von FIG 8 nach dem zusätzlichen Aufsetzen eines Gehäuses 24. In FIG 9 sind insbesondere die Leiterplatte 1, ein Teil der elektronischen Bauelemente 4, die Zusatzeinheit 5, eine der Verbindungseinheiten 9 und deren Aufbau, die Brückenstruktur 12 und deren Ausgestaltung, ein Teil einer Stromschiene 16 und deren Ausgestaltung und der Kühlkörper 21 erkennbar. Von der Stromschiene 16 ist nur deren Zusatzeinheits-Endabschnitt 18 mit seinem Bezugszeichen versehen. Weiterhin ist aus FIG 9 eine weitere vorteilhafte Ausgestaltung erkennbar, nämlich dass die Aufnahmen 11 (alternativ: die Steckkontakte 10) in die Zusatzeinheits-Endabschnitte 18 eingepresst sind.

Aus FIG 9 ist auch ein wesentlicher Vorteil der vorliegenden Erfindung erkennbar. Konkret steht der Bereich 25 bei der erfindungsgemäßen Zusatzeinheit 5 als Nutzraum für die Anordnung von Komponenten der Zusatzeinheit 5 zur Verfügung. Im Stand der Technik müsste der Bereich 25 hingegen freigelassen werden.

Zusammengefasst betrifft die vorliegende Erfindung somit folgenden Sachverhalt:

Eine elektronische Leistungsbaugruppe, die insbesondere als Umrichtereinheit ausgebildet sein kann, weist eine Leiterplatte 1 auf, welche Leiterbahnen 2 zum Führen von Leistungsströmen aufweist. Die Leistungsbaugruppe weist weiterhin eine oberhalb der Leiterplatte 1 angeordnete Zusatzeinheit 5 auf, die eine der Leiterplatte 1 zugewandte Unterseite 6 aufweist. Die Zusatzeinheit 5 weist elektronische Komponenten 7 auf, die mit den Leiterbahnen 2 der Leiterplatte 1 über Verbindungseinheiten 9 elektrisch verbunden sind. Die Verbindungseinheiten 9 weisen jeweils einen Steckkontakt 10 und eine Aufnahme 11 für den jeweiligen Steckkontakt 10 auf. Die Steckkontakte 10 sind an der Unterseite 6 der Zusatzeinheit 5 angeordnet und die Aufnahmen 11 sind direkt oder indirekt an den Leiterbahnen 2 der Leiterplatte 1 befestigt. Alternativ können umgekehrt die Aufnahmen 11 an der Unterseite 6 der Zusatzeinheit 5 angeordnet sein und die Steckkontakte 10 direkt oder indirekt an den Leiterbahnen 2 der Leiterplatte 1 befestigt sein.

Die vorliegende Erfindung weist viele Vorteile auf. Insbesondere steht bei gleichem Gesamtvolumen der elektronischen Leistungsbaugruppe ein größeres Nutzvolumen für die Anordnung von Leiterbahnen 2, weiteren Leiterbahnen 3 und elektronischen Bauelemente 4 oder auch von mechanischen Komponenten und Strukturen zur Verfügung. Weiterhin vereinfacht sich die Montage der elektronischen Leistungsbaugruppe.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Elektronische Leistungsbaugruppe, insbesondere Umrichtereinheit,
- wobei die Leistungsbaugruppe eine Leiterplatte (1) aufweist, welche Leiterbahnen (2) zum Führen von Leistungsströmen aufweist,
- wobei die Leistungsbaugruppe eine oberhalb der Leiterplatte (1) angeordnete Zusatzeinheit (5) aufweist, die eine der Leiterplatte (1) zugewandte Unterseite (6) aufweist,
- wobei die Zusatzeinheit (5) elektronische Komponenten (7) aufweist, die mit den Leiterbahnen (2) der Leiterplatte (1) über Verbindungseinheiten (9) elektrisch verbunden sind,
**dadurch gekennzeichnet,**
- **dass** die Verbindungseinheiten (9) jeweils einen Steckkontakt (10) und eine Aufnahme (11) für den jeweiligen Stecckontakt (10) aufweisen und
- **dass** die Steckkontakte (10) an der Unterseite (6) der Zusatzeinheit (5) angeordnet sind und die Aufnahmen (11) direkt oder indirekt an den Leiterbahnen (2) der Leiterplatte (1) befestigt sind oder umgekehrt die Aufnahmen (11) an der Unterseite (6) der Zusatzeinheit (5) angeordnet sind und die Steckkontakte (10) direkt oder indirekt an den Leiterbahnen (2) der Leiterplatte (1) befestigt sind.

2. Leistungsbaugruppe nach Anspruch 1,
**dadurch gekennzeichnet,**
**dass** die Leistungsbaugruppe eine aus einem elektrisch isolierenden Material, insbesondere einem Kunststoff, bestehende Brückenstruktur (12) aufweist, die an ihrer von der Leiterplatte (1) abgewandten und der Zusatzeinheit (5) zugewandten Oberseite (14) eine Auflagefläche (15) aufweist, so dass die Brückenstruktur (12) eine Montageebene für die Zusatzeinheit (5) bildet, und dass die Zusatzeinheit (5) mit ihrer Unterseite (6) direkt oder über ein Zwischenelement (23) auf der Auflagefläche (15) der Brückenstruktur (12) aufliegt.

3. Leistungsbaugruppe nach Anspruch 2,
**dadurch gekennzeichnet,**
- **dass** die Leistungsbaugruppe abgewinkelte Stromschienen (16) aufweist, die jeweils einen Leiterplatten-Endabschnitt (17), einen Zusatzeinheits-Endabschnitt (18) und einen die beiden jeweiligen Endabschnitte (17, 18) verbindenden Zwischenabschnitt (19) aufweisen,
- **dass** die Leiterplatten-Endabschnitte (17) parallel zur Leiterplatte (1) verlaufen und an den Leiterbahnen (2) befestigt sind,
- **dass** die Zwischenabschnitte (19) sich im wesentlichen orthogonal zur Leiterplatte (1) erstrecken,
- **dass** die Zusatzeinheits-Endabschnitte (18) in der Montageebene verlaufen und
- **dass** an den von den Zwischenabschnitten (19) abgewandten Enden der Zusatzeinheits-Endabschnitte (18) jeweils eine der Aufnahmen (11) oder einer der Steckkontakte (10) befestigt ist.

4. Leistungsbaugruppe nach Anspruch 3,
**dadurch gekennzeichnet,**
**dass** die Zusatzeinheits-Endabschnitte (18) in der Montageebene gesehen über die Brückenstruktur (12) überstehen, so dass die an den von den Zwischenabschnitten (19) abgewandten Enden der Zusatzeinheits-Endabschnitte (18) angeordneten Aufnahmen (11) oder Steckkontakte (10) beim Aufsetzen der Zusatzeinheit (5) auf die Brückenstruktur (12) in Richtung auf die Leiterplatte (1) zu nachgeben können.

5. Leistungsbaugruppe nach Anspruch 3 oder 4,
**dadurch gekennzeichnet,**
**dass** die Aufnahmen (11) oder die Steckkontakte (10) in die Zusatzeinheits-Endabschnitte (18) eingepresst sind.

6. Leistungsbaugruppe nach einem der obigen Ansprüche,
**dadurch gekennzeichnet,**
**dass** die an der Unterseite (6) der Zusatzeinheit (5) angeordneten Steckkontakte (10) oder Aufnahmen (11) gegenüber der Unterseite (6) der Zusatzeinheit (5) zurückgesetzt sind, so dass die Steckkontakte (10) oder Aufnahmen (11) bezüglich der Unterseite (6) der Zusatzeinheit (5) versenkt angeordnet sind.
